# EUROPEAN PATENT APPLICATION

(11) **EP 1 693 339 A1**
(43) Date of publication of application: **23.08.2006**
(21) Application number: 06002949.3
(22) Date of filing: 14.02.2006
(51) Int. Cl.: B81C 1/00

(54) **MEMS device and manufacturing method of MEMS device**

(30) Priority: 16.02.2005 JP 2005038742; 16.11.2005 JP 2005331437
(71) Applicant: SEIKO EPSON CORPORATION, Shinjuku-ku, Tokyo 163-0811 (JP)
(72) Inventor: Sato, Akira, Suwa-shi Nagano-ken 392-8502 (JP); Inaba, Shogo, Suwa-shi Nagano-ken 392-8502 (JP)
(74) Representative: HOFFMANN EITLE

(57) **Abstract**

A MEMS device includes a wiring laminated through an interlayer insulating film on a semiconductor substrate, the interlayer insulating film partially opened up to an upper portion of the substrate, and a structure disposed in the opening, wherein on a sidewall of the interlayer insulating film exposed in the opening that faces the structure and on a surface of the uppermost layer of the interlayer insulating film, a silicon nitride film is formed.

## Description

### BACKGROUND

### 1. Technical Field

The invention relates to a MEMS device provided with a structure on a semiconductor substrate and a manufacturing method of a MEMS device.

### 2. Related Art

In recent years, a sensor, a resonator and a communication device, which, by making use of the MEMS (Micro Electro Mechanical System) technology, are provided with a MEMS device on a semiconductor substrate, are gathering attention. The MEMS device is a functional device that is made of a fine structure manufactured on a semiconductor substrate by use of a semiconductor manufacturing process. The structure has a movable portion (movable electrode) having a cantilever beam formation or a both-ends supported beam formation, which deforms owing to an external force such as an electric force or acceleration, and a fixed portion (fixed electrode). For instance, a MEMS device provided with a comb-shaped movable electrode and a comb-shaped fixed electrode such as shown in JP-A-2004-276200 is known.

In such a MEMS device, when a wiring or a circuit element for extracting an electric signal of the structure is formed on the same substrate, in a peripheral portion of the structure, wiring layers are laminated.

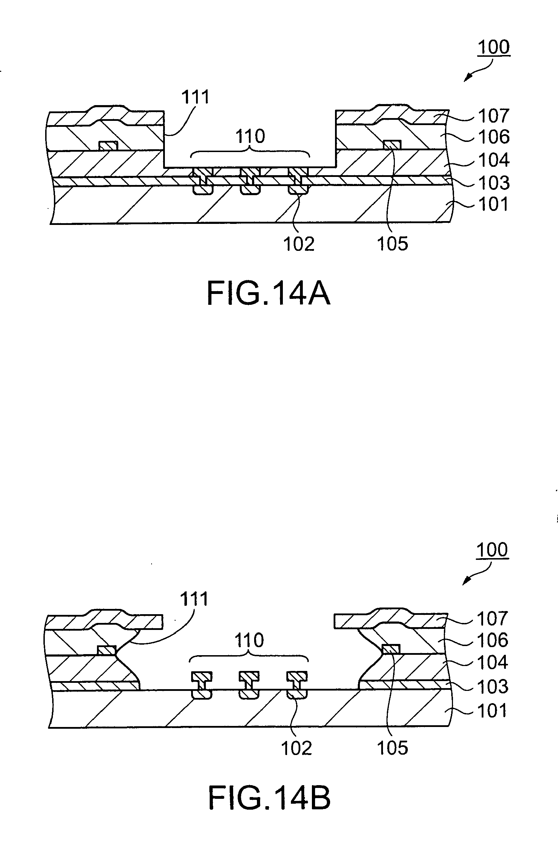

The situation will be specifically described with reference to Figs. 14A and 14B. Figs. 14A and 14B are sectional views partially showing a manufacturing process of a MEMS device having a configuration as mentioned above.

As shown in Fig. 14A, a MEMS device 100 is formed in such a manner that a lower electrode 102 is formed on a semiconductor substrate 101, an insulating film 103 is formed thereon, and the insulating film is partially removed to form a structure 110. On the structure 110, an interlayer insulating film 104, a wiring 105 connected to a lower electrode 102, an interlayer insulating film 106 and a passivation film 107 are sequentially laminated. Thereafter, the passivation film 107 and interlayer insulating films 106 and 104 in an upper portion of the structure 110 are anisotropically etched (dry etching) to a surface of the structure 110 to form an opening 111. At the end, as shown in Fig. 14B, part of the interlayer insulating film 104 and the insulating film 103 are isotropically etched (wet etching), and thereby the structure 110 is released.

However, in such a manufacturing process, in some cases, in the isotropic etching for releasing the structure 110, the interlayer insulating films 104 and 106 are simultaneously etched up to the wiring 105 to damage the wiring 105. In this case, it is considered to displace the wiring 105 to a place where the etching does not proceed. However, the integration degree of the MEMS device 100 is deteriorated. Furthermore, in the opening 111 of the MEMS device 100 configured thus, since the interlayer insulating films 104 and 106 are exposed, the moisture resistance is poor and thereby the reliability of the MEMS device 100 is largely deteriorated.

### SUMMARY

An advantage of some aspects of the invention is to provide a MEMS device that does not damage a wiring in a release step of a structure and is excellent in the moisture resistance and improved in the reliability, and a manufacturing method of the MEMS device.

A MEMS device according to an aspect of the invention is a MEMS device where a wiring is laminated on a semiconductor substrate through an interlayer insulating film, the interlayer insulating film is partially opened up to an upper portion of the substrate, and in the opening a structure is disposed, wherein on a sidewall of the interlayer insulating film exposed in the opening that faces the structure and on a surface of the uppermost layer of the interlayer insulating film a silicon nitride film is formed.

According to the configuration, since on a sidewall of the insulating film that faces the structure and on a surface of the uppermost layer of the interlayer insulating film a silicon nitride film is formed, the interlayer insulating film is not exposed, the moisture resistance becomes excellent and the reliability of the MEMS device can be improved.

Furthermore, in the MEMS device according to another aspect of the invention, it is preferable that below the lowermost layer of the interlayer insulating film that faces the structure a base portion that is projected from the interlayer insulating film and located on a layer same as the structure is formed.

According to the configuration, in the isotropic etching in the release step of the structure, an etching solution can be inhibited from intruding in the interlayer insulating film and thereby the moisture resistance can be improved.

Furthermore, a manufacturing method according to another aspect of the invention of a MEMS device at least includes forming an insulating film on a semiconductor substrate, forming a lower electrode on the semiconductor substrate, partially removing the insulating film to form a structure forming film on the insulating film, etching the structure forming film to form a shape of a structure, forming an interlayer insulating film and a wiring above the structure forming film, etching the interlayer insulating film above the structure at least up to a surface of the structure to form an opening, forming a silicon nitride film on the structure, a surface of the interlayer insulating film and a sidewall of the opening, etching the silicon nitride film on the structure and etching the interlayer insulating film and the insulating film in contact with the structure to release the structure.

According to the manufacturing method of a MEMS device, when on a sidewall of the interlayer insulating film that faces the structure a silicon nitride film is formed, the silicon nitride film can be utilized as a protective film in the etching. Accordingly, there is no risk of the isotropic etching for releasing the structure further etching the interlayer insulating film to damage the wiring. Furthermore, since the silicon nitride film covers from a surface of the interlayer insulating film to a sidewall, a manufacturing method of a MEMS device that is excellent in the moisture resistance and improved in the reliability can be provided.

Furthermore, in the manufacturing method according to another aspect of the invention of a MEMS device, in the etching the structure forming layer to form a shape of the structure, a base portion that is a pedestal of the silicon nitride film is preferably formed in the same step.

According to the manufacturing method of a MEMS device, when a base portion that is a pedestal of the silicon nitride film is formed simultaneously in the step of forming a shape of the structure, a step can be reduced. Furthermore, when the base portion is disposed, in the isotropic etching in the release step of the structure, since an etching solution can be inhibited from intruding in the interlayer insulating film, the moisture resistance can be improved.

Furthermore, in the manufacturing method according to another aspect of the invention of a MEMS device, in the etching the interlayer insulating film above the structure, desirably, at the first the isotropic etching is applied and thereafter the anisotropic etching is applied.

According to the manufacturing method of a MEMS device, when the interlayer insulating film is at the first isotropically etched, a sidewall of the etched interlayer insulating film can be formed in inclined plane; accordingly, in the formation of the silicon nitride film, the step coverage can be improved. In particular, when a multi-layered wiring is formed, the advantage in improving the step coverage is large.

Furthermore, a MEMS device according to another aspect of the invention is a MEMS device where a wiring is laminated on a semiconductor substrate through an interlayer insulating film, the interlayer insulating film is partially opened up to an upper portion of the semiconductor substrate, and in the opening a structure is disposed, wherein at least on a sidewall of the interlayer insulating film exposed in the opening that faces the structure a corrosion resistant film is formed.

According to the configuration, since on a sidewall of the interlayer insulating film in the opening that faces the structure a corrosion resistant film is formed, the interlayer insulating film is not exposed; accordingly, the moisture resistance becomes excellent and thereby the reliability of the MEMS device can be improved.

In the MEMS device according to another aspect of the invention, the corrosion resistant film is preferably formed of a film made of a material selected from TiN, W, Mo or polysilicon.

According to the configuration, when, on a sidewall of the interlayer insulating film in the opening that faces the structure, as the corrosion resistant film, a film made of a material selected from TiN, W, Mo or polysilicon is formed, in comparison with an existing state where the interlayer insulating film is exposed, the moisture resistance becomes more excellent and thereby the reliability of the MEMS device can be improved.

Furthermore, the materials such as TiN, W, Mo and polysilicon, being materials used in the semiconductor processes, can be readily used.

A manufacturing method according to another aspect of the invention of a MEMS device at least includes forming an insulating film on a semiconductor substrate, forming a lower structure forming film on the insulating film, etching the lower structure forming film to form a shape of a lower structure, forming an interlayer insulating film on the lower structure, forming an upper structure forming film on the interlayer insulating film, etching the upper structure forming film to form a shape of an upper structure, forming an interlayer insulating film and a wiring above the upper structure, etching the interlayer insulating film above the upper structure to form an opening, forming a corrosion resistant film above the upper structure and on a sidewall of the interlayer insulating film in the opening, etching the corrosion resistant film located above the upper structure, and etching the interlayer insulating film in contact with the upper structure and the lower structure to release the upper structure and lower structure.

According to the manufacturing method of a MEMS device, since on a sidewall of the interlayer insulating film in the opening that faces the structure a corrosion resistant film is formed, the corrosion resistant film can be used as a protective film in the etching. Accordingly, even when in the isotropic etching for releasing the structure the interlayer insulating film is further etched, the wiring is not damaged. Furthermore, since the sidewall of the opening is covered with the corrosion resistant film, a manufacturing method of a MEMS device that is, in comparison with an existing state where an interlayer insulating film is exposed, more excellent in the moisture resistance and improved in the reliability can be provided.

Furthermore, a manufacturing method according to another aspect of the invention of a MEMS device at least includes forming an insulating film on a semiconductor substrate, forming a lower electrode on the semiconductor substrate, partially removing the insulating film to form a structure forming film on the insulating film, etching the structure forming film to form a shape of a structure, forming an interlayer insulating film and a wiring above the structure forming film, etching the interlayer insulating film above the structure to form an opening, forming a corrosion resistant film above the structure and on a sidewall of the interlayer insulating film in the opening, etching the corrosion resistant film above the structure, and etching the interlayer insulating film in contact with the structure to release the structure.

According to the manufacturing method of a MEMS device, since on a sidewall of the interlayer insulating film in the opening that faces the structure a corrosion resistant film is formed, the corrosion resistant film can be used as a protective film in the etching. Accordingly, even when in the isotropic etching for releasing the structure the interlayer insulating film is further etched, the wiring is not damaged. Furthermore, since the sidewall of the opening is covered with the corrosion resistant film, in comparison with an existing state where an interlayer insulating film is exposed, a manufacturing method of a MEMS device that is more excellent in the moisture resistance and improved in the reliability can be provided.

In the manufacturing method according to another aspect of the invention of a MEMS device, the corrosion resistant film is preferably formed of a film made of a material selected from TiN, W, Mo or polysilicon.

Thus, the materials such as TiN, W, Mo and polysilicon, being materials that are used in the semiconductor processes, can be readily formed. The films can provide MEMS devices excellent in the moisture resistance and improved in the reliability.

### BRIEF DESCRIPTION OF THE DRAWINGS

The invention will be described with reference to the accompanying drawings, wherein like numbers reference like elements.

Figs. 1A and 1B are schematic configuration diagrams of a MEMS device in a first embodiment according to the invention, Fig. 1A being a plan view of a MEMS device, Fig.1B being a sectional view along an A-A chain line of Fig. 1A.

Figs. 2A through 2D are schematic sectional views showing manufacturing steps of a MEMS device in a second embodiment.

Figs. 3A through 3D are schematic sectional views showing manufacturing steps of a MEMS device in the second embodiment.

Figs. 4A through 4D are schematic sectional views showing manufacturing steps of a MEMS device in the second embodiment.

Fig. 5 is a schematic plan view showing shapes and layouts of a structure and a base portion in the second embodiment.

Figs. 6A and 6B are schematic configuration diagrams of a MEMS device in a third embodiment according to the invention, Fig. 6A being a plan view of a MEMS device, Fig. 6B being a sectional view along a B-B chain line of Fig. 6A.

Figs. 7A through 7E are schematic sectional views showing manufacturing steps of a MEMS device in a fourth embodiment.

Figs. 8A through 8D are schematic sectional views showing manufacturing steps of a MEMS device in the fourth embodiment.

Figs. 9A through 9D are schematic sectional views showing manufacturing steps of a MEMS device in the fourth embodiment.

Figs. 10A through 10C are schematic sectional views showing manufacturing steps of a MEMS device in the fourth embodiment.

Figs. 11A and 11B are schematic configuration diagrams of a MEMS device in a fifth embodiment according to the invention, Fig. 11A being a plan view of a MEMS device, Fig.11B being a sectional view along a C-C chain line of Fig. 11A.

Figs. 12A through 12D are schematic sectional views showing manufacturing steps of a MEMS device in a sixth embodiment.

Figs. 13A through 13C are schematic sectional views showing manufacturing steps of a MEMS device in the sixth embodiment.

Figs. 14A and 14B are schematic sectional views of manufacturing steps for explaining problems that the invention is to solve.

### DESCRIPTION OF EXEMPLARY EMBODIMENTS

In what follows, embodiments that embody the invention will be described with reference to the drawings.

### First Embodiment

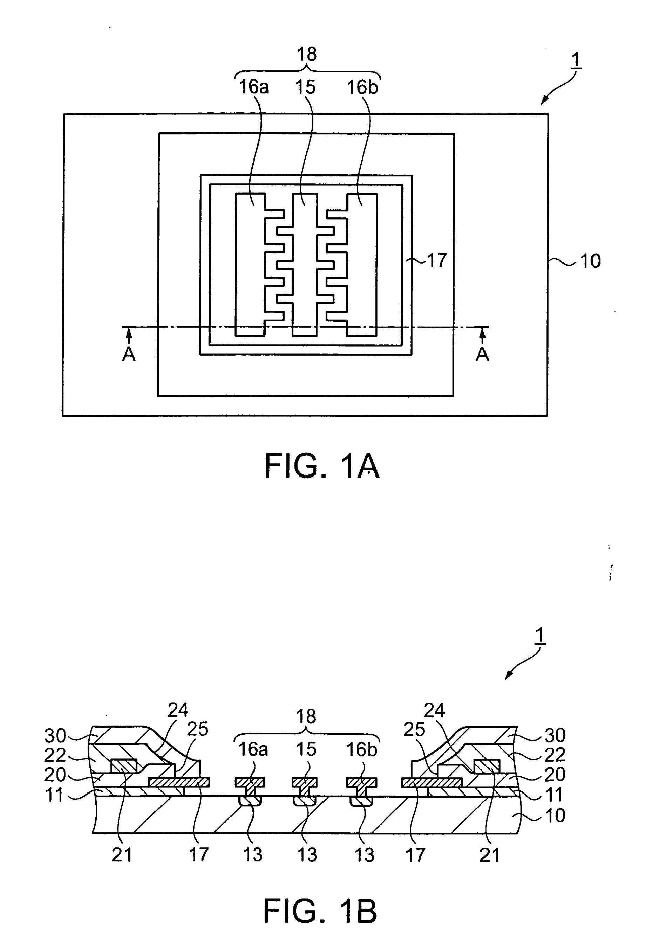

Figs. 1A and 1B are schematic configuration diagrams showing an embodiment of a MEMS resonator as a MEMS device according to the invention. Fig. 1A is a plan view of the MEMS device and Fig. 1B is a sectional view along an A-A chain line of Fig. 1A.

In Figs. 1A and 1B, a MEMS device 1 is formed in such a manner that on a semiconductor substrate 10 made of silicon, a structure 18 constituted of a movable electrode 15 and fixed electrodes 16a and 16b, which are made of polysilicon, are formed. On the semiconductor substrate 10, an N type lower electrode 13 is formed and therethrough electrically connected to the structure 18. Furthermore, in a peripheral portion that faces the structure 18, an insulating film 11 that is a thermally-oxidized film formed on the semiconductor substrate 10 is formed, and thereon an interlayer insulating film 20, a wiring 21 and an interlayer insulating film 22 are sequentially laminated. The wiring 21 is made of Al or Cu and connected to the lower electrode 13 or a circuit element formed on the semiconductor substrate 10 (not shown).

Between the insulating film 11 and the interlayer insulating film 20, a base portion 17 made of polysilicon is formed. The base portion 17 is located on a layer same as the structure 18, projects toward the structure 18 more than the interlayer insulating films 20 and 22 and is formed so as to surround the structure 18. While covering from a top surface of the interlayer insulating film 22 through a sidewall of the interlayer insulating film 20 to the base portion 17, a silicon nitride (Si₃N₄) film 30 is formed. Furthermore, the sidewall of the interlayer insulating film 22 is formed in inclined plane from the top surface so that the silicon nitride film 30 may readily cover.

Thus, the MEMS device 1 has, on the semiconductor substrate 10, the structure 18 and the wiring 21, the structure 18 being opened at an upper portion thereof, in the periphery thereof the wiring 21 being laminated through the interlayer insulating films 20 and 22.

The MEMS device 1 having the above configuration, when AC voltage is applied between one of the fixed electrodes 16a and a grounding electrode (not shown in the drawing), generates an electrostatic force between the comb-shaped fixed electrode 16a and the movable electrode 15 to planarly vibrate the movable electrode 15, and extracts a resonant frequency of the vibration from the other fixed electrode 16b.

Thus, in the MEMS device 1 according to the embodiment, since the silicon nitride film 30 is formed on the sidewalls of the interlayer insulating films 20 and 22 that face the structure 18 and a surface of the interlayer insulating film 22, the interlayer insulating films 20 and 22 are not exposed. Furthermore, the insulating film (SiO₂ film) 11, being a thermally oxidized film different from the interlayer insulating films 20 and 22, is a film high in the moisture resistance. Accordingly, the MEMS device 1 becomes excellent in the moisture resistance and thereby the reliability thereof can be improved.

Furthermore, since the base portion 17 made of polysilicon is disposed between the insulating film 11 and the interlayer insulating film 20, in the manufacturing step of the MEMS device 1, the etching solution can be inhibited from intruding in the interlayer insulating film 20. Accordingly, the moisture resistance can be improved as well.

### Second Embodiment

In the next place, a manufacturing method of a MEMS device 1 will be described. In the manufacture of the MEMS device 1, a semiconductor CMOS process is used.

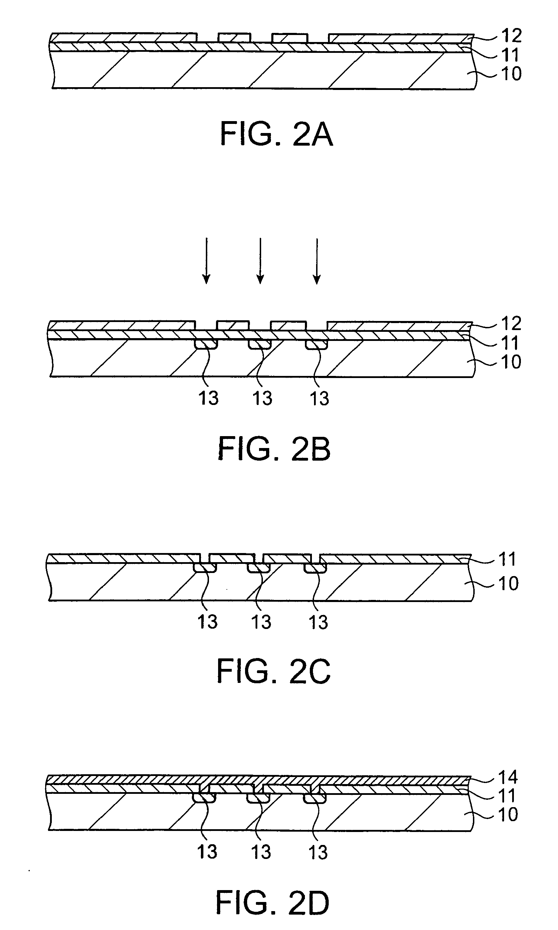

Figs. 2A through 2D, 3A through 3D and 4A through 4D are schematic sectional views showing manufacturing steps of the MEMS device 1.

In the beginning, in Fig. 2A, an insulating film 11 that is a thermally oxidized film (SiO₂ film) is formed on a semiconductor substrate 10 made of silicon, and photoresist is coated thereon to form a photoresist film 12. The photoresist film 12 is patterned into a predetermined shape. Thereafter, as shown in Fig. 2B, from above the patterned semiconductor substrate 10, a P ion is injected to form an N type lower electrode 13 on the semiconductor substrate 10. Subsequently, the photoresist film 12 is removed, followed by once more coating the photoresist, and further followed by patterning to partially remove the insulating film 11 above the lower electrode 13. Then, as shown in Fig. 2C, the insulating film 11 is partially etched to the lower electrode 13 to remove the photoresist. In the next place, from thereabove, as shown in Fig. 2D, a structure forming film 14 made of polysilicon is formed. At this time, also to a portion from where the insulating film 11 is partially removed, the polysilicon goes around.

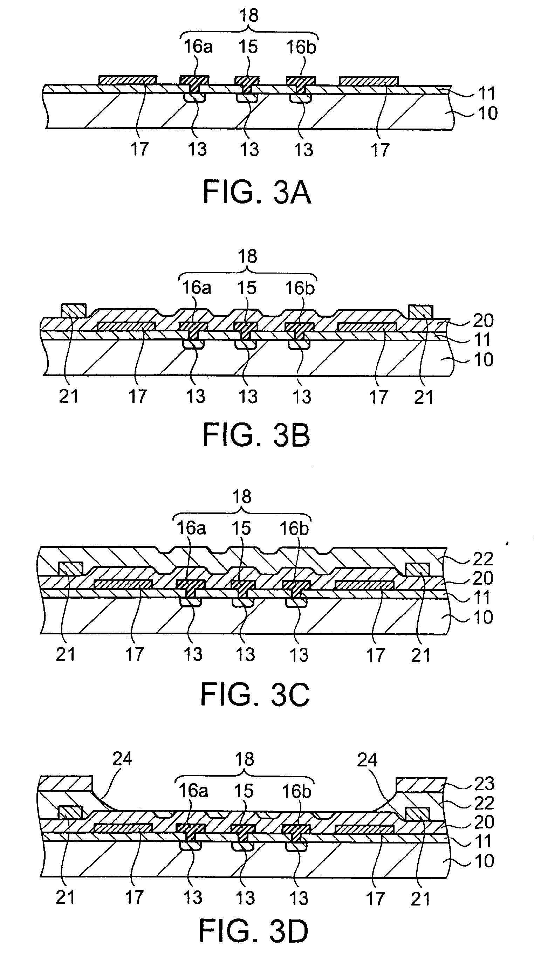

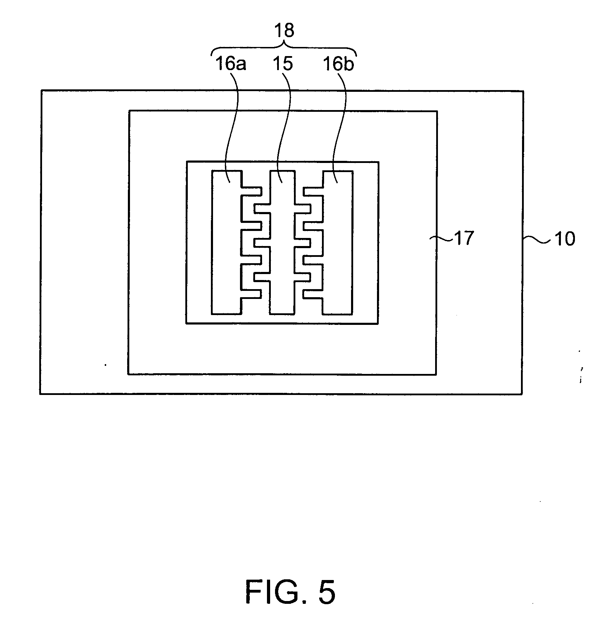

In the next place, as shown in Fig. 3A, the structure forming film 14 is patterned and thereby shapes of the structure 18 (movable electrode 15 and fixed electrodes 16a and 16b) and the base portion 17 are separated. Fig. 5 is a schematic plan view showing shapes and formations of the structure 18 and the base portion 17. The movable electrode 15 and the fixed electrodes 16a and 16b that constitute the structure 18 each have a comb-shaped projection, the comb-shaped projections being arranged so as to engage with each other. Furthermore, the base portion 17 is formed so as to surround the structure 18.

As shown in Fig. 3B, on the structure 18 and the base portion 17, an interlayer insulating film 20 such as a SiO₂ film is formed, followed by further patterning thereon to form a wiring 21. The wiring 21 is made of Al or Cu and connected to a lower electrode 13 disposed on the semiconductor substrate 10 or a circuit element disposed on the semiconductor substrate 10.

In the next place, as shown in Fig. 3C, from above the wiring 21, an interlayer insulating film 22 such as a SiO₂ film is formed. Then, as shown in Fig. 3D, with a photoresist film 23 on a surface of the interlayer insulating film 22 as a mask, the interlayer insulating film 22 located above the structure 18 and the base portion 17 are subjected to the isotropic etching (wet etching). A sidewall of the etched interlayer insulating film 22 becomes, owing to the isotropic etching, a sidewall 24 that is formed in inclined plane.

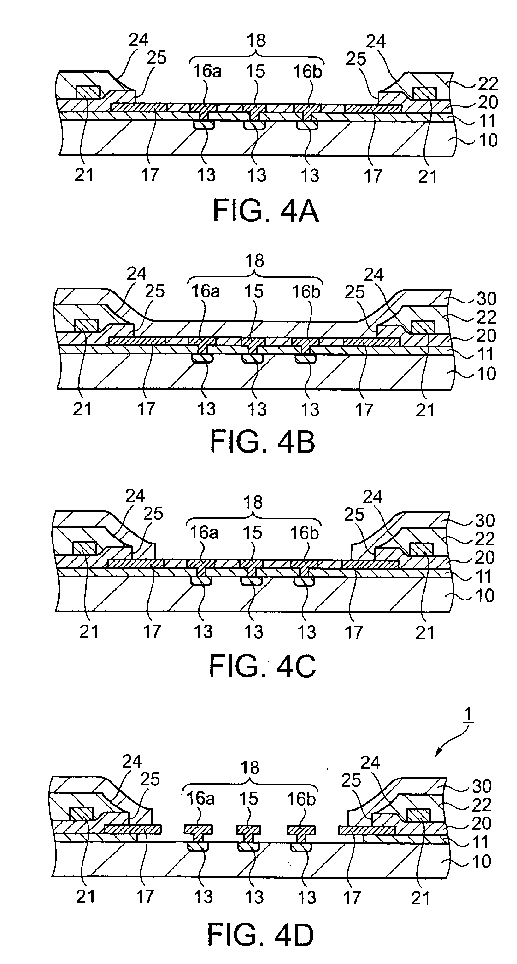

Subsequently, as shown in Fig. 4A, the anisotropic etching (dry etching) is applied to the interlayer insulating film 20. At this time, the etching is carried out until surfaces of at least the structure 18 and the base portion 17 are exposed. A sidewall of the etched interlayer insulating film 20 becomes, owing to the anisotropic etching, a substantially vertical sidewall 25.

Then, as shown in Fig. 4B, while covering from a top surface of the interlayer insulating film 22 through a sidewall of the interlayer insulating film 20 to a surface of the structure 18, by use of the plasma CVD, a silicon nitride (Si₃N₄) film 30 is formed.

In the next place, as shown in Fig. 4C, the silicon nitride film 30 located above the structure 18 and the base portion 17 is subjected to the anisotropic etching until surfaces of at least the structure 18 and the base portion 17 are exposed.

At the end, as shown in Fig. 4D, the isotropic etching is applied with the interlayer insulating film 20 and the insulating film 11 below a surface of the structure 18 as a sacrificing layer, and thereby the structure 18 is released.

In the isotropic etching of the interlayer insulating films 20 and 22 and the insulating film 11, a hydrofluoric acid based etching solution is used and in the anisotropic etching a fluorine or chlorine based etching gas is used. Furthermore, when the anisotropic etching is applied to the silicon nitride film 30, an etching gas such as CF₄ is used.

As mentioned above, according to the manufacturing method of the embodiment of the MEMS device, since the silicon nitride film 30 is formed on sidewalls of the interlayer insulating films 20 and 22 that face the structure 18, the silicon nitride film 30 can be used as a protective film in the etching. From this, in the isotropic etching where the structure 18 is released, the interlayer insulating films 20 and 22, even when further etched, do not damage the wiring 21. Furthermore, since the silicon nitride film 30 covers a portion from a surface of the interlayer insulating film 22 to the sidewalls 24 and 25 thereof, a manufacturing method of a MEMS device 1 excellent in the moisture resistance and improved in the reliability can be provided.

Furthermore, according to the manufacturing method of the MEMS device 1, since the base portion 17 that becomes a pedestal of the silicon nitride film 30 is simultaneously formed in the forming a shape of the structure 18, the step can be eliminated. Still furthermore, when the base portion 17 is disposed, in the isotropic etching in the releasing the structure 18, an etching solution can be inhibited from intruding into the interlayer insulating film 20 and the moisture resistance of the MEMS device 1 can be improved.

Furthermore, according to the manufacturing method of the MEMS device 1, when the interlayer insulating film 22 is subjected to the isotropic etching first, since a sidewall of the etched interlayer insulating film 22 can be formed in inclined plane, in the forming the silicon nitride film 30, the step coverage can be improved.

Still furthermore, according to the manufacturing method of the MEMS device 1, when an electrode pad for connecting to the wiring 21 to further connect to an external terminal is opened after the etching to release the structure 18 is carried out, since there is no need of protecting the electrode pad with the resist in the etching to release the structure 18, the MEMS device 1 can be efficiently manufactured. Third Embodiment

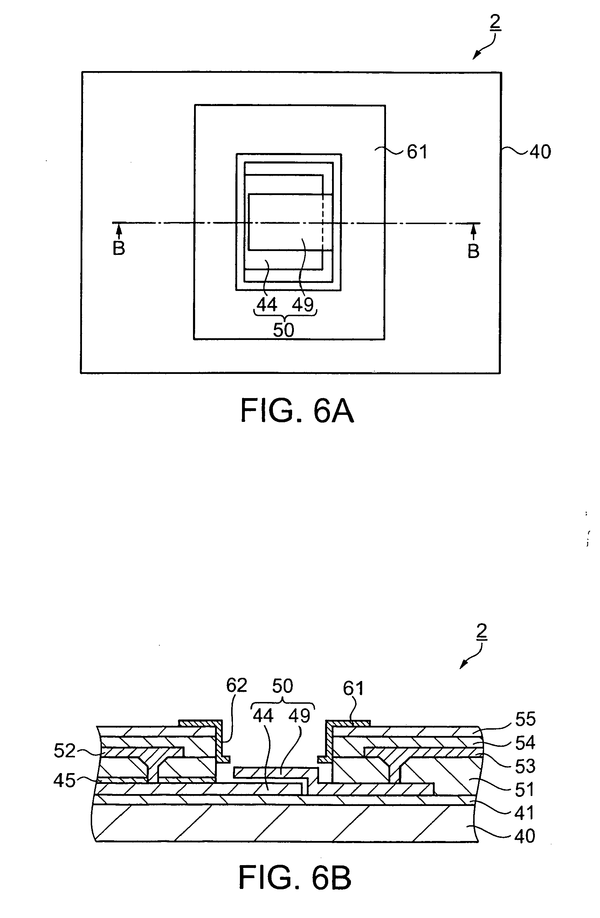

Figs. 6A and 6B are schematic configuration diagrams showing another embodiment of a MEMS resonator as a MEMS device according to the invention. Fig. 6A is a plan view of the MEMS device and Fig. 6B is a sectional view along a B-B chain line of the Fig. 6A.

In Fig. 6B, a MEMS device 2 is formed in such a manner that on a semiconductor substrate 40 made of silicon, through a nitride film 41, a structure 50 constituted of an upper structure 49 and a lower structure 44 both made of polysilicon are formed. The upper structure 49 and the lower structure 44 each work as an electrode, and the upper structure 49 is disposed above the lower structure 44 so as to partially overlap in a thickness direction with the lower structure 44 with a definite spacing.

Furthermore, in a peripheral portion that faces the structure 50, on the nitride film 41, interlayer insulating films 45 and 51, wirings 52 and 53 and an interlayer insulating film 54 are sequentially laminated and at the uppermost layer a passivation film 55 such as a silicon nitride film is formed. The wirings 52 and 53 are made of Al or Cu and connected to the lower structure 44 and the upper structure 49 through via holes that penetrate through the interlayer insulating films 45 and 51. Furthermore, on the semiconductor substrate 40, a circuit element (not shown in the drawing) may be formed to form a peripheral circuit.

Thus, in the MEMS device 2, on the semiconductor substrate 40 the structure 50 and wirings 52 and 53 are formed, an upper portion of the structure 50 is opened, in the peripheral portion thereof the wirings 52 and 53 are laminated through the interlayer insulating films 51 and 54.

Furthermore, while covering a portion from a sidewall 62 of an opening portion obtained by opening an upper portion of the structure 50 to part of the passivation film 55, a corrosion resistant film 61 is formed. The corrosion resistant film 61 is formed of a film of a material selected from TiN, W, Mo or polysilicon. The materials have the corrosion resistance to a hydrofluoric acid based etching solution.

In the MEMS device 2 like this, when DC voltage is applied to the upper structure 49, between the upper structure 49 and the lower structure 44 that faces thereto 49, an electrostatic force is generated. Here, when AC voltage is further applied to the upper structure 49, the electric force increases or decreases to vibrate, and thereby the upper structure 49 shifts so as to come near or come apart the lower structure 44 to vibrate. At this time, on a surface of the lower structure 44, electric charges move to flow a current to the lower structure 44. Since the vibration is repeated, an intrinsic resonant frequency is outputted from the lower structure 44.

Thus, in the MEMS device 2 according to the embodiment, an upper portion of the structure 50 is opened, and the interlayer insulating film 54 and part of the interlayer insulating film 51 that are exposed on the sidewall 62 of the opening are covered with the corrosion resistant film 61. The corrosion resistant film 61 is formed of a film of a material selected from TiN, W, Mo or polysilicon and excellent in the moisture resistance. Accordingly, in comparison with an existing state where the interlayer insulating film is exposed, the moisture resistance becomes excellent and the reliability of the MEMS device 2 can be improved.

Furthermore, since on the sidewall 62 of the opening the corrosion resistant film 61 having the corrosion resistance to the hydrofluoric acid based etching solution is disposed, in the releasing the structure 50 in the manufacturing step of the MEMS device 2, the corrosion resistant film 61 works as a protective film. As a result, the etching solution is inhibited from corroding the interlayer insulating film 54 to reach and damage the wirings 52 and 53. Fourth Embodiment

In the next place, a manufacturing method of the MEMS device 2 will be described. In the manufacturing method of the MEMS device 2, a semiconductor CMOS process is used.

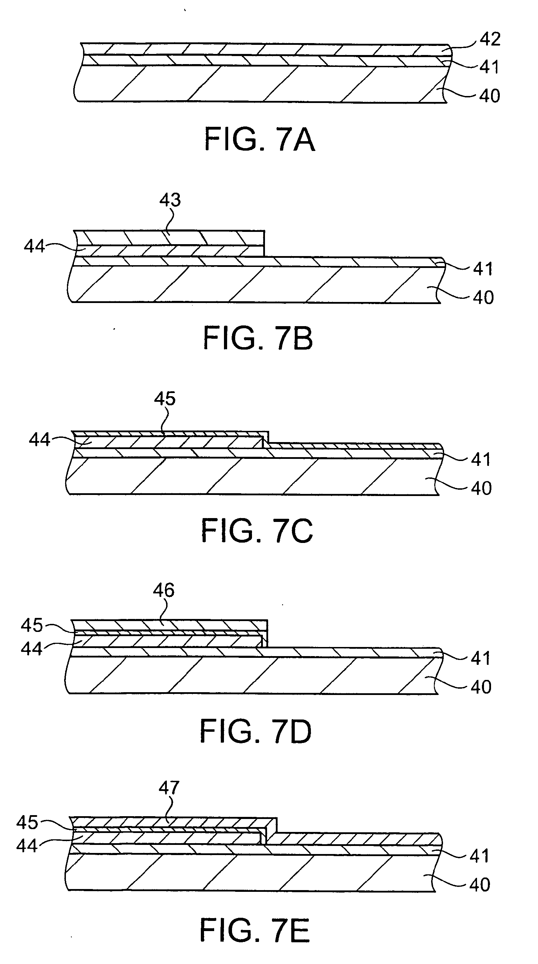

Figs. 7A through 7E through 10A through 10C are schematic sectional views showing the manufacturing process of the MEMS device 2.

In Fig. 7A, on a semiconductor substrate 40 made of silicon a nitride film 41 such as a Si₃N₄ film is formed and thereon a lower structure forming film 42 made of polysilicon is formed. On the lower structure forming film 42, a photoresist film 43 is formed, followed by patterning in a shape of a lower structure. Thereafter, as shown in Fig. 7B, with the patterned photoresist film 43 as a mask, the lower structure forming film 42 is etched to form a shape of the lower structure 44. Further thereafter, as shown in Fig. 7C, the photoresist film 43 is removed, and on the lower structure 44 and the nitride film 41 an interlayer insulating film 45 such as a SiO₂ film is formed.

Subsequently, on the interlayer insulating film 45 a photoresist film 46 is formed and the photoresist film 46 is patterned so as to leave an upper portion of the lower structure 44. Then, as shown in Fig. 7D, with the patterned photoresist film 46 as a mask the interlayer insulating film 45 is etched. Thereafter, as shown in Fig. 7E, the photoresist film 46 is removed and thereon an upper structure forming film 47 made of polysilicon is formed.

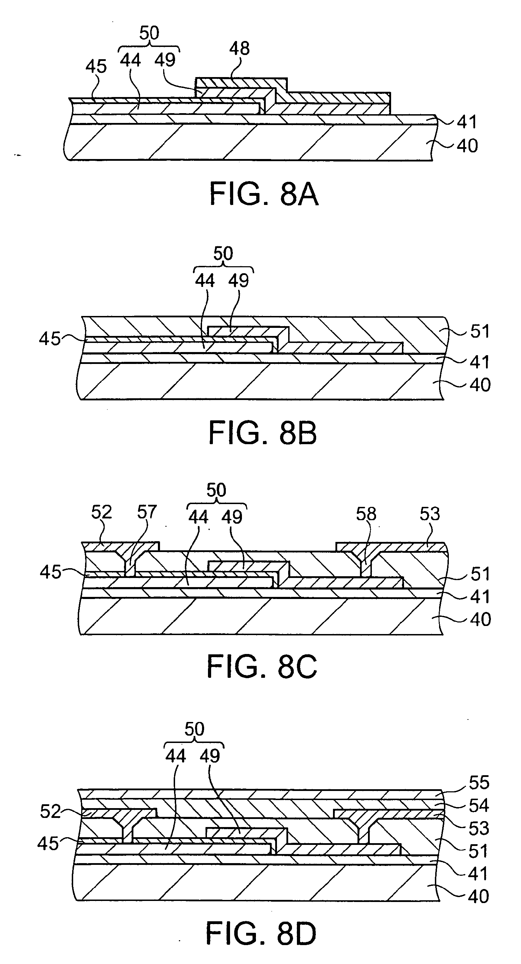

In the next place, on the upper structure forming film 47, a photoresist film 48 is formed, followed by patterning in a shape of the upper structure. Thereafter, as shown in Fig. 8A, with the patterned photoresist film 48 as a mask the upper structure forming film 47 is etched to form a shape of the upper structure 49. Then, as shown in Fig. 8B, the photoresist film 48 is removed and thereon an interlayer insulating film 51 such as a SiO₂ film is formed.

Subsequently, as shown in Fig. 8C, in order to connect to the lower structure 44 and the upper structure 49, via holes 57 and 58 are formed penetrating through the interlayer insulating films 51 and 45, and on the interlayer insulating film 51 wirings 52 and 53 are patterned and formed. In the next place, as shown in Fig. 8D, after the wirings 52 and 53 are formed, thereon an interlayer insulating film 54 such as a SiO₂ film and a passivation film 55 such as a Si₃N₄ film are formed respectively.

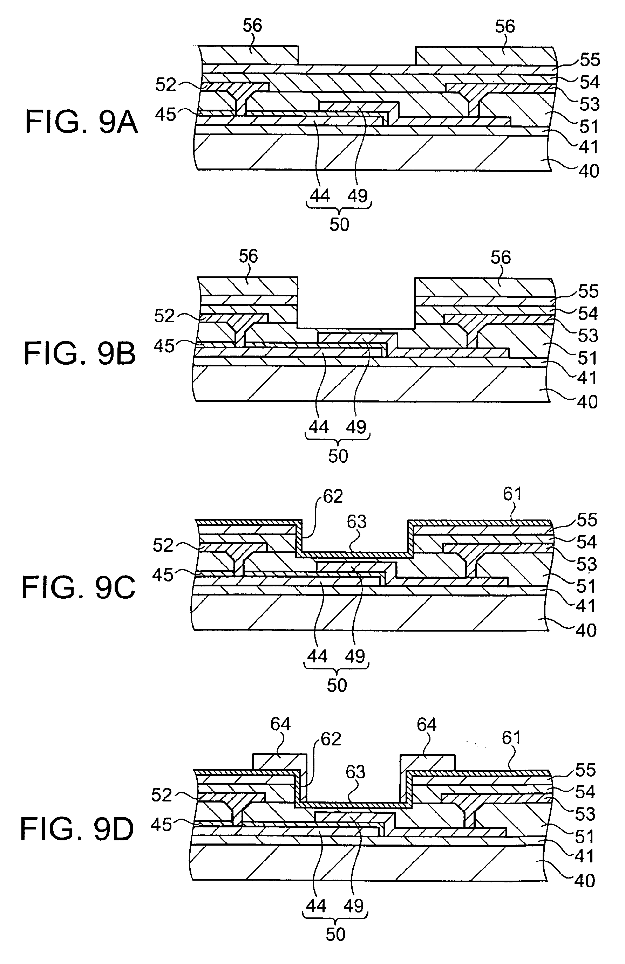

Then, as shown in Fig. 9A, on the passivation film 55 a photoresist film 56 is formed, followed by patterning so as to remove the photoresist film 56 above the structure 50. Then, as shown in Fig. 9B, with the patterned photoresist film 56 as a mask the passivation film 55, the interlayer insulating film 54 and part of the interlayer insulating film 51 are anisotropically etched (dry etching) to form an opening.

After that, as shown in Fig. 9C, the photoresist film 56 is removed, and thereon a corrosion resistant film 61 is formed. The corrosion resistant film 61 is formed so as to cover a portion from a surface of the passivation film 55 to a sidewall 62 of the opening and a bottom surface 63 of the opening. In the corrosion resistant film 61, a film made of a material selected from TiN, W, Mo or polysilicon is used.

Subsequently, on the corrosion film 61, a photoresist film 64 is formed, and, as shown in Fig. 9D, the photoresist film 64 is patterned so as to remain over from the sidewall 62 of the opening to the corrosion resistant film 61 formed above the passivation film 55.

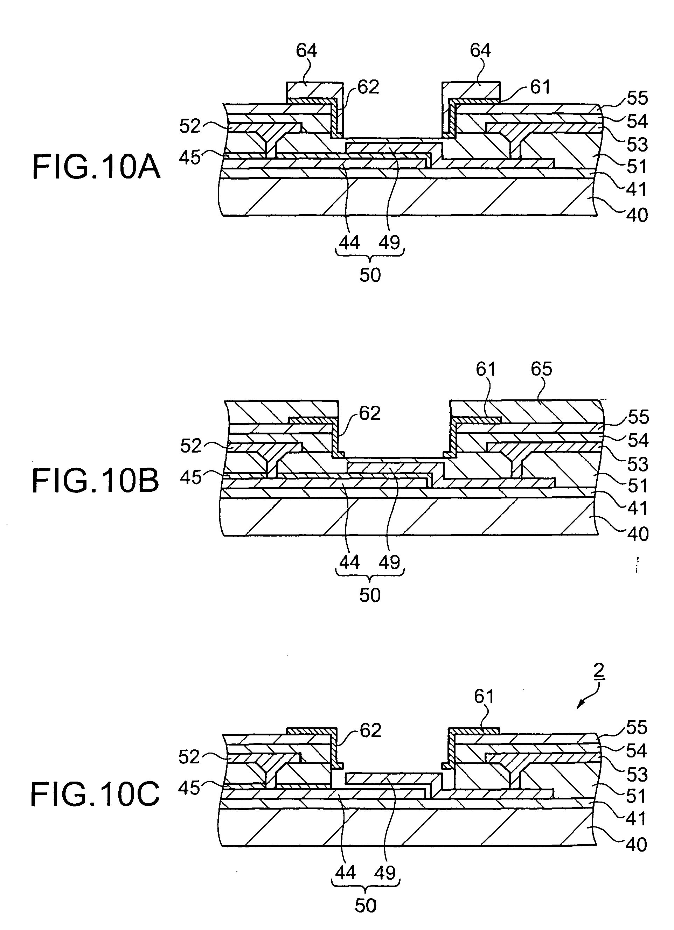

Then, as shown in Fig. 10A, with the patterned photoresist film 64 as a mask the corrosion resistant film 61 is etched. Thus, the corrosion resistant film 61 formed at a bottom portion in the opening and the corrosion resistant film 61 formed on a surface of the passivation film 55 are partially removed.

Subsequently, the photoresist film 64 is removed, and, as shown in Fig. 10B, a photoresist film 65 is once more formed, followed by patterning so as to remove the photoresist film 65 above the structure 50 in the opening.

Thereafter, with the photoresist film 65 as a mask and with the interlayer insulating films 51 and 45 in contact with the structure 50 as sacrificing layers, the isotropic etching (wet etching) is applied to release the structure 50 made of the upper structure 49 and the lower structure 44.

Finally, the photoresist film 65 is removed, and thereby the MEMS device 2 shown in Fig. 10C comes to completion.

In the anisotropic etching for forming the opening above the structure 50, fluorine or chlorine based etching gas is used, and in the isotropic etching of the sacrificing layers in contact with the structure 50 a hydrofluoric acid based etching solution is used.

As mentioned above, according to the manufacturing method of the embodiment of the MEMS device 2, the corrosion resistant film 61 is formed on the sidewall 62 of the opening that faces the structure 50. The corrosion resistant film 61 uses a film made of a material appropriately selected from TiN, W, Mo or polysilicon and the film made of the material has excellent corrosion resistance to a hydrofluoric acid based etching solution. Accordingly, since the corrosion resistant film 61 can be utilized as a protective film in the etching, when the isotropic etching is applied to release the structure 50, the interlayer insulating film 54 is inhibited from being etched to damage the wirings 52 and 53.

Furthermore, since a material that is used in the corrosion resistant film 61 has the moisture resistance and the corrosion resistant film 61 covers the sidewall 62 of the opening, in comparison with an existing state where an interlayer insulating film is exposed, a manufacturing method of the MEMS device 2 that is excellent in the moisture resistance and improved in the reliability can be provided. Fifth Embodiment

In the next place, as a fifth embodiment, a MEMS device that includes on a semiconductor substrate a structure having a configuration explained in the first embodiment and has a corrosion resistant film on a sidewall of an opening will be described. Like numbers as the first embodiment reference like elements and will be described.

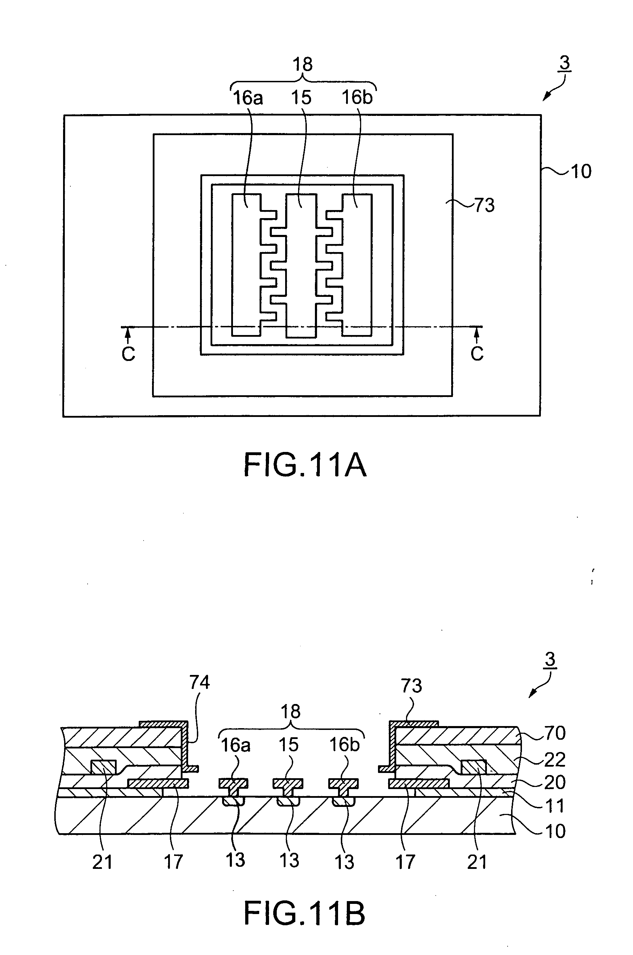

Figs. 11A and 11B are schematic configuration diagrams showing still another embodiment of a MEMS resonator as a MEMS device according to the invention. Fig. 11A is a plan view of a MEMS device and Fig. 11B is a sectional view along a C-C chain line in Fig. 11A.

In Figs. 11A and 11B, in a MEMS device 3, on a semiconductor substrate 10 made of silicon, a structure 18 constituted of a movable electrode 15 made of polysilicon and fixed electrodes 16a and 16b is formed. On the semiconductor substrate 10, an N type lower electrode 13 is formed and electrically connected to the structure 18. Furthermore, in a peripheral portion that faces the structure 18, an insulating film 11 that is a thermally-oxidized film formed on the semiconductor substrate 10 is formed, and thereon an interlayer insulating film 20, a wiring 21, an interlayer insulating film 22 and a passivation film 70 are sequentially laminated. The wiring 21 is made of Al or Cu and connected to the lower electrode 13 or a circuit element formed on the semiconductor substrate 10 (not shown).

Thus, in the MEMS device 3, on the semiconductor substrate 10, the structure 18 and the wiring 21 are provided, an upper portion of the structure 18 is opened, and in a peripheral portion thereof the wiring 21 is laminated through the interlayer insulating film 20 and 22.

Furthermore, between the insulating film 11 and the interlayer insulating film 20, a base portion 17 made of polysilicon is formed. The base portion 17 is located on a layer same as the structure 18, projects toward the structure 18 more than the interlayer insulating films 20 and 22 and is formed into a shape that surrounds the structure 18.

Still furthermore, over from a sidewall 74 of an opening formed by opening an upper portion of the structure 18 to part of the passivation film 70, a corrosion resistant film 73 is formed. The corrosion resistant film 73 is formed of a film of a material selected from TiN, W, Mo or polysilicon.

Thus, in the MEMS device 3 according to the embodiment, the upper portion of the structure 18 is opened and an interlayer insulating film 22 and part of an interlayer insulating film 20 both exposed on a sidewall 74 of the opening are covered with a corrosion resistant film 73. The corrosion resistant film 73 is constituted of a film made of a material selected from TiN, W, Mo or polysilicon and excellent in the moisture resistance. Accordingly, in comparison with an existing state where an interlayer insulating film is exposed, the moisture resistance becomes more excellent and the reliability of the MEMS device 3 can be improved.

Furthermore, since on the sidewall 74 of the opening the corrosion resistant film 73 having the corrosion resistance to a hydrofluoric acid based etching solution is disposed, the corrosion resistant film 73 becomes a protective film in the releasing the structure 18 in the manufacturing process insulating film the MEMS device 3. Accordingly, the etching solution is inhibited from corroding the interlayer insulating film 22 and reaching the inside to damage the wiring 21.

### Sixth Embodiment

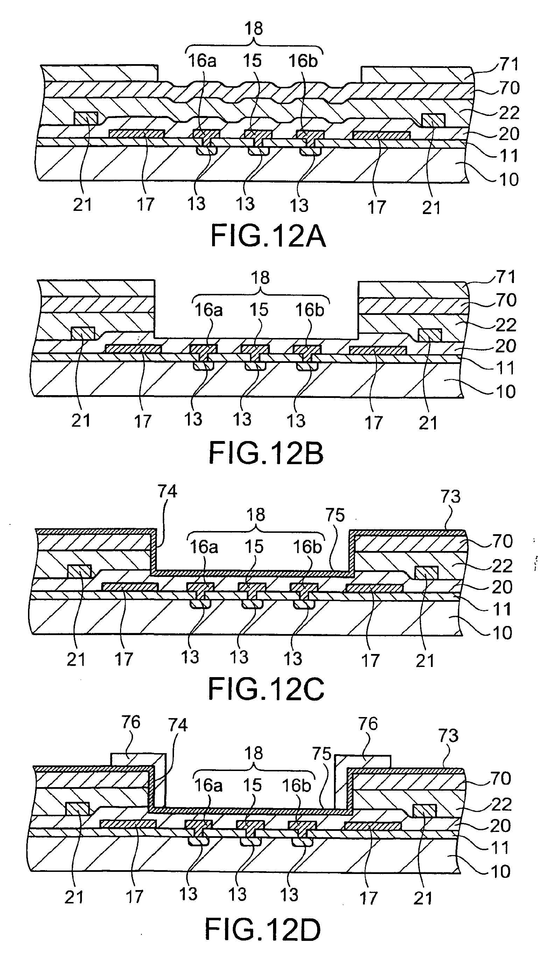

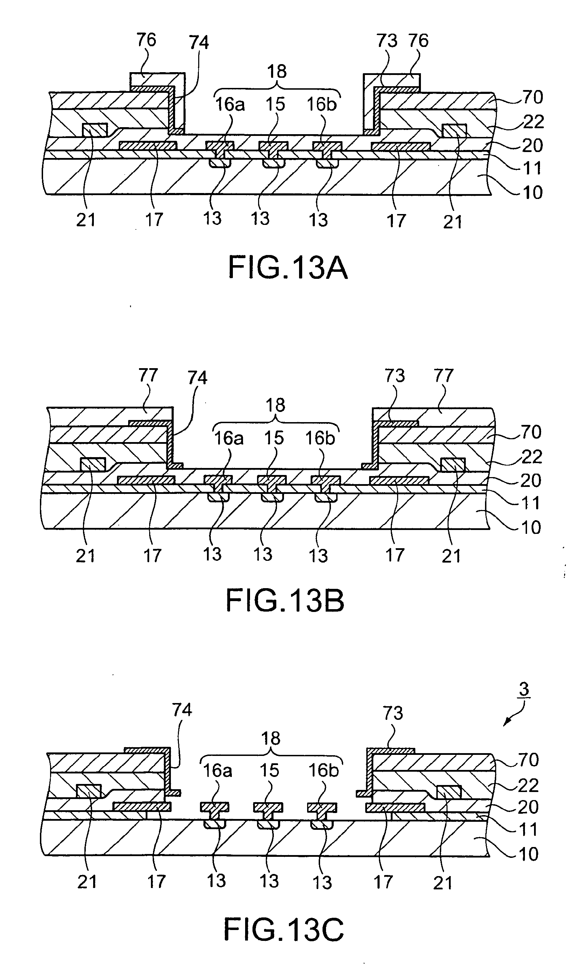

In the next place, a manufacturing method of the MEMS device 3 will be described. In the manufacturing method of the MEMS device 3, a semiconductor CMOS process is used. The manufacturing method of the MEMS device 3 according to the embodiment is same as that of the second embodiment in steps from Figs. 2A through 3C described in the second embodiment. Accordingly, like numbers reference to like constituent elements, descriptions thereof are omitted, and steps after Fig. 3C will be described with reference to Figs. 12A through 12D and 13A through 13C.

In Fig. 3C, on a wiring 21, an interlayer insulating film 22 such as a SiO₂ film is formed. Thereafter, on the interlayer insulating film 22 a passivation film 70 such as a Si₃N₄ film is formed. Then, as shown in Fig. 12A, on the passivation film 70 a photoresist film 71 is formed followed by patterning so as to remove the photoresist film 71 above a structure 18. Subsequently, as shown in Fig. 12B, with the patterned photoresist 71 as a mask, the anisotropic etching (dry etching) is applied to the passivation film 70, the interlayer insulating film 22 and part of the interlayer insulating film 20 to form an opening.

In the next place, as shown in Fig. 12C, the photoresist film 71 is removed, followed by forming thereon a corrosion resistant film 73. The corrosion resistant film 73 is formed so as to cover from a surface of the passivation film 70 to a sidewall 74 of the opening and a bottom surface 75 of the opening. Furthermore, the corrosion resistant film 73 uses a film made of a material appropriately selected from TiN, W, Mo or polysilicon.

Subsequently, on the corrosion resistant film 73, a photoresist film 76 is formed, and, as shown in Fig. 12D, the photoresist film 76 is patterned so as to remain from a sidewall 74 of the opening to the corrosion resistant film 73 formed on the passivation film 70.

In the next place, as shown in Fig. 13A, with the patterned photoresist film 76 as mask, the corrosion resistant film 73 is etched. Thus, the corrosion resistant film 73 formed on the bottom portion in the opening and the corrosion resistant film 73 formed on a surface of the passivation film 70 are partially removed.

Then, the photoresist film 76 is removed, as shown in Fig. 13B, a photoresist film 77 is once more formed followed by patterning so as to remove the photoresist film 77 above the structure 18 in the opening.

Thereafter, with the photoresist film 77 as mask and with the interlayer insulating film 20 and the insulating film 11 both in contact with the structure 18, the isotropic etching (wet etching) is applied to release the structure 18 constituted of a movable electrode 15 and fixed electrodes 16a and 16b.

Finally, the photoresist film 77 is removed, and thereby the MEMS device 3 shown in Fig. 13C comes to completion.

In the anisotropic etching for forming an opening portion above the structure 18, fluorine based or chlorine based etching gas is used, and in the isotropic etching for etching the sacrificing layers in contact with the structure 18 a hydrofluoric acid based etching solution is used.

As mentioned above, according to the manufacturing method according to the embodiment of the MEMS device 3, the corrosion resistant film 73 is on the sidewall 74 of the opening that faces the structure 18. The corrosion resistant film 73 uses a film made of a material selected from TiN, W, Mo or polysilicon and has excellent corrosion resistance to the hydrofluoric acid based etching solution. Accordingly, since the corrosion resistant film 73 can be utilized as a protective film in the etching, when the isotropic etching is applied to release the structure 18, the etching solution is inhibited from etching the interlayer insulating film 22 to damage the wirings 21.

Furthermore, since a material that is used in the corrosion resistant film 73 has the moisture resistance and the corrosion resistant film 73 covers the sidewall 74 of the opening, a manufacturing method of the MEMS device 3 that is, in comparison with an existing state where an interlayer insulating film is exposed, excellent in the moisture resistance and improved in the reliability can be provided.

In the embodiment, the structure and the base portion are formed of polysilicon, however, other gate electrode materials that are silicided in the CMOS transistor can be used to perform. Furthermore, as a material of the semiconductor substrate, for instance, Si, Ge, SiGe, SiC, SiSn, PbS, GaAs, InP, GaP, GaN and ZnSe can be used.

Still furthermore, the corrosion resistant film in the embodiment is formed of a film made of a material appropriately selected from TiN, W, Mo or polysilicon that has the corrosion resistance to the hydrofluoric acid based etching solution. However, the material is not restricted to these, and, as far as a material has the corrosion resistance to the etching solution that is used to release the structure, any material can be used.

In the embodiments according to the invention, a MEMS resonator is described as an example. However, the invention can be applied as well to an actuator, a jyro sensor and an acceleration sensor that utilize the MEMS technology and the identical advantages can be obtained.

## Claims

1. A MEMS device comprising:
a wiring laminated through an interlayer insulating film on a semiconductor substrate;
the interlayer insulating film partially opened up to an upper portion of the semiconductor substrate; and
a structure disposed in the opening, wherein
on a sidewall of the interlayer insulating film exposed in the opening that faces the structure and on a surface of the uppermost layer of the interlayer insulating film, a silicon nitride film is formed.

2. The MEMS device according to claim 1, wherein below the lowermost layer of the interlayer insulating film that faces the structure a base portion that is projected from the interlayer insulating film and located on a layer same as the structure is formed.

3. A manufacturing method of a MEMS device at least comprising:
forming an insulating film on a semiconductor substrate;
forming a lower electrode on the semiconductor substrate;
partially removing the insulating film to form a structure forming film on the insulating film;
etching the structure forming film to form a shape of a structure;
forming an interlayer insulating film and a wiring above the structure forming film;
etching the interlayer insulating film above the structure at least up to a surface of the structure to form an opening;
forming a silicon nitride film on the structure, a surface of the interlayer insulating film and a sidewall of the opening;
etching the silicon nitride film above the structure; and
etching the interlayer insulating film and the insulating film both in contact with the structure to release the structure.

4. The manufacturing method according to claim 3, wherein in the etching the structure forming film to form a shape of a structure a base portion that is a pedestal of the silicon nitride film is formed in the same step.

5. The manufacturing method according to claim 3 or claim 4, wherein, in the etching the interlayer insulating film above the structure, at the first, the isotropic etching is applied and subsequently the anisotropic etching is applied.

6. A MEMS device comprising:
a wiring laminated through an interlayer insulating film on a semiconductor substrate;
the interlayer insulating film partially opened up to an upper portion of the substrate; and
a structure disposed in the opening, wherein
at least on a sidewall of the interlayer insulating film exposed in the opening that faces the structure a corrosion resistant film is formed.

7. The MEMS device according to claim 6, wherein
the corrosion resistant film is formed of a film made of a material selected from TiN, W, Mo or polysilicon.

8. A manufacturing method of a MEMS device at least comprising:
forming an insulating film on a semiconductor substrate;
forming a lower structure forming film on the insulating film;
etching the lower structure forming film to form a shape of a lower structure;
forming an interlayer insulating film on the lower structure;
forming an upper structure forming film above the interlayer insulating film;
etching the upper structure forming film to form a shape of an upper structure;
forming an interlayer insulating film and a wiring above the upper structure;
etching the interlayer insulating film above the upper structure to form an opening;
forming a corrosion resistant film above the upper structure and on a sidewall of the interlayer insulating film in the opening;
etching the corrosion resistant film located above the upper structure; and
etching the interlayer insulating film in contact with the upper structure and the lower structure to release the upper structure and lower structure.

9. A manufacturing method of a MEMS device at least comprising:
forming an insulating film on a semiconductor substrate;
forming a lower electrode on the semiconductor substrate;
partially removing the insulating film to form a structure forming film above the insulating film;
etching the structure forming film to form a shape of a structure;
forming an interlayer insulating film and a wiring above the structure forming film;
etching the interlayer insulating film above the structure to form an opening;
forming a corrosion resistant film above the structure and on a sidewall of the interlayer insulating film in the opening;
etching the corrosion resistant film above the structure; and
etching the interlayer insulating film in contact with the structure to release the structure.

10. The manufacturing method according to claim 8 or claim 9, wherein the corrosion resistant film is a film made of a material selected from TiN, W, Mo or polysilicon.
